Europäisches Patentamt

European Patent Office

Office européen des brevets

(19)

(11) EP 0 734 614 B1

(12) **EUROPÄISCHE PATENTSCHRIFT**

(45) Veröffentlichungstag und Bekanntmachung des Hinweises auf die Patenterteilung:
**11.04.2001 Patentblatt 2001/15**

(21) Anmeldenummer: **95902757.4**

(22) Anmeldetag: **13.12.1994**

(51) Int Cl.$^7$: **H03B 29/00**

(86) Internationale Anmeldenummer:
**PCT/DE94/01479**

(87) Internationale Veröffentlichungsnummer:
**WO 95/17039 (22.06.1995 Gazette 1995/26)**

(54) **SCHMALBANDIGER ARBITRÄRER HF-MODULATIONS- UND RAUSCH GENERATOR**

NARROW BAND, ARBITRARY HF MODULATION AND NOISE GENERATOR

GENERATEUR DE BRUIT ET DE MODULATION ARBITRAIRE EN H.F. A BANDE ETROITE

(84) Benannte Vertragsstaaten:
**DE DK ES FR GB IT SE**

(30) Priorität: **14.12.1993 DE 4342520**

(43) Veröffentlichungstag der Anmeldung:
**02.10.1996 Patentblatt 1996/40**

(73) Patentinhaber: **FORSCHUNGSZENTRUM JÜLICH GMBH**
**52425 Jülich (DE)**

(72) Erfinder:
• **MEUTH, Hermann**
**D-53173 Bonn (DE)**
• **HEINRICHS, Günter**
**D-41849 Wassenberg (DE)**
• **SCHNASE, Alexander**
**D-52146 Würselen (DE)**
• **STOCKHORST, Hans**
**D-53175 Bonn (DE)**

(56) Entgegenhaltungen:
**EP-A- 0 338 742        GB-A- 1 490 964**
**US-A- 5 057 795**

• **ELECTRONIC DESIGN., Bd.38, Nr.8, 26. April 1990, HASBROUCK HEIGHTS, NEW JERSEY Seite 108, XP000124434 K. LACANETTE 'CREATE AN ACCURATE NOISE GENERATOR'**

**Beschreibung**

Die Erfindung betrifft einen Generator für Hochfrequenz-(HF)-Schwingungen sowie ein Verfahren zur arbiträren HF-Modulation. Dabei handelt es sich jedoch nicht um reine Schwingungen. Vielmehr kann durch zeitliche Variation (Modulation) der drei HF-Parameter Frequenz, Phase und/oder Amplitude Information übermittelt werden.

Die Modulationsfunktionen können willkürlich (arbiträr) gewählt werden, solange hierdurch der Wesensgehalt der HF-Schwingung nicht ganz verloren geht (Schmalbandigkeit). Bei der Erzeugung von Rauschen unterliegen die Modulationsfunktionen bestimmten Zufallsbedingungen.

In der Meßtechnik werden zunehmend Frequenz- und Amplitudenmodulationsquellen und insbesondere Rauschquellen eingesetzt, die einen geeigneten Frequenzbereich über decken müssen. Diese Methode ermöglicht eine gleichzeitige Erfassung von relevanten, eventuell entsprechend gewichteten Frequenzbeiträgen. Für Audioanwendungen ist dies fast durchweg üblich, da bei Sprachübertragungen die jeweilige Erfassung einer einzigen Frequenzkomponente keine schlüssige Aussage erlaubt.

Aus EP 0 338 742 A2 ist ein Pseudozufalls-Syntheziser bekannt, bei welchem die unteren Bits eines in einem Akkumulator gespeicherten Wortes durch einen Pseudozufalls-Syntheziser variiert werden und das Ergebnis im wesentlichen D/A gewandelt wird.

Bei dem von K. Lacanette beschriebenen Geräuschgenerator (K. Lacanette, Create an accurate noise generator, Electronic Design., Bd. 38, Nr. 8, 26. April 1990, Hasbrouck Hights, New Jersey, Seite 108, XP000124434) handelt es sich ebenfalls um einen Pseudozufalls-Syntheziser. Bei diesem Generator werden die Ausgangssignale zweier paralleler Pseudozufalls-Syntheziser jeweils einzeln verzögert, gefiltert, D/A gewandelt und anschließend addiert.

Wegen der Modulationsanforderung heutiger Vielkanalübertragung sind auch auf dem Hochfrequenzsektor solche Techniken interessant. HF-modulierte Signale treten in der Regel bei Kommunikationsübertragung auf; zu Test messungen an Übertragungsstrecken verschlüsselter Signale sind Rauschsignale wünschenswert bzw. erfor lich.

Modulations- und Rauschsignale auf dem Hochfrequenzsektor (für Frequenzen von mehr als einigen Megahertz) können bisher nur durch (analoge) Frequenzkonversions verfahren realisiert werden.

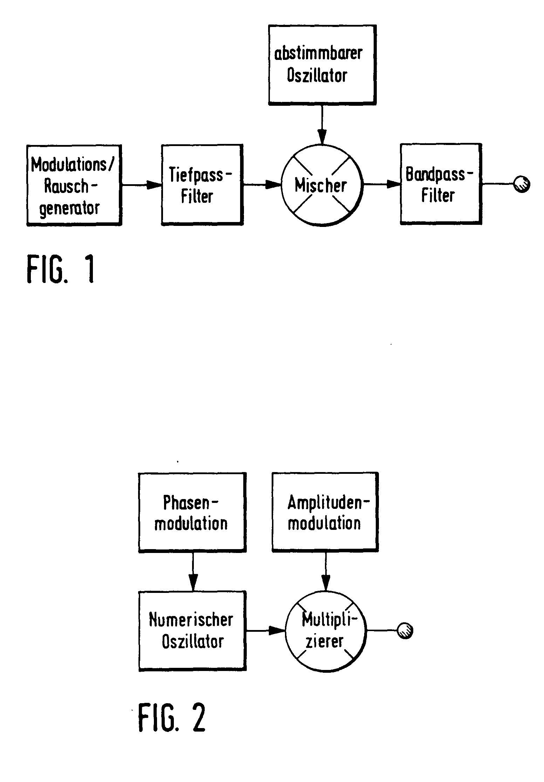

Bei einem solchen Konversionsverfahren wird der Modulations- bzw. Rauschanteil niederfrequent analog oder digital mittels einer Signalquelle und nachfolgenden Filtern erzeugt und daraufhin analog in der Frequenz "verschoben" (Abb. 1).

Diese Verschiebung um eine vorgebbare Frequenz (Träger) wird durch Frequenzmischer erzielt. Die meßtechnisch erforderliche Variation von Träger und Modulations-bzw. Rauschcharakteristik erfolgt getrennt, das letztere durch Variation der Filterparameter. Dieses sequentielle Verfahren führt zu Fehlern in den resultierenden Signalen. Es kann damit nur ein Modulations-bzw. Rauschsignal, das sich um die verschobene Frequenz (Träger) zu beiden Seiten gleich (symmetrisch) verhält, erzeugt werden.

Eine mathematisch präzise Synthese und Signalbeinflussung ist bei den bisher verwendeten Verfahren nicht möglich. Um daher ein Meßobjekt zu charakterisieren, ist eine zeitversetzte Bestimmung des an das Meßobjekt angelegten Meßsignals und danach des Meßsignals nach Durchlauf des Meßobjekts erforderlich, soweit nur ein Meßkanal zur Verfügung steht, bzw. ein zweiter Meßkanal.

Im ersten Fall stellt dies erhebliche Anforderungen an die zeitliche Invarianz (Reproduzierbarkeit), im zweiten Fall an den Gleichlauf beider Kanäle. Als Folge werden zusätzlich zu den eigentlichen Testmessungen am Meßobjekt laufend Kalibrier- und Vergleichsmessungen erforderlich.

Ein rein digital direkt synthetisiertes Signal kann dagegen im Prinzip vorausberechnet werden. Systematische Abweichungen können durch Vorwegnahme kompensiert werden. Direkt synthetisierte Rauschsignale werden heute im Audiobereich durch arbiträre Wortgeneratoren erzeugt, wobei bei Frequenzen bis in den Kilohertzbereich eine fortlaufende Berechnung in Echtzeit möglich ist.

Im Hochfrequenz-Bereich kann dieses Verfahren so nicht mehr eingesetzt werden, da bei der schnellen zeitlichen Veränderlichkeit der Signale die Ausgabegeschwindigkeit solcher Wortgeneratoren nicht nachkommt und/oder eine ausreichende Speichertiefe nicht zur Verfügung steht.

Eine Werteberechnung in Echtzeit ist aus technischen Gründen ausgeschlossen. Eine limitierte Speichertiefe kann zwar durch eine periodische Ausgabe einer Wertesequenz wettgemacht werden, eignet sich daher aber nicht zur Rauscherzeugung hoher Qualität, die durch Aperiodizität charakterisiert ist.

Aufgabe der Erfindung ist es, einen schmalbandigen arbiträren HF-Modulationsgenerator zu schaffen, der insbesondere zur schmalbandigen HF-Rauscherzeugung geeignet ist, und bei welchem arbiträre, rein digital synthetisierte Amplituden- und Phasenmodulationen bei freier Frequenzvariation möglich sind.

Die Erfindung besteht darin, daß die Phasen zweier parallel laufender numerisch kontrollierter Oszillatoren (NCO) gemäß einer vorherigen Berechnung geeignet moduliert werden. Die beiden so erzeugten Signalsequenzen werden addiert, wodurch eine gleichzeitige, falls gewünscht, korrellierte Amplituden- und Phasenmodula tion des resultierenden HF-Signals erreicht wird. Die gesamte Signalgenerierung des Verfahrens geschieht auf rein digitalem Wege. Resultate und Toleranzen sind daher präzis vorausberechenbar und stets reproduzierbar.

Diese Lösung für einen rein digitalen schmalbandigen HF-Modulationsgenerator orientiert sich an der Verfügbarkeit kommerzieller integrierter Schaltkreise; sie erlaubt im Vergleich zu anderen denkbaren Lösungen die derzeit höchste Datenverarbeitungsrate und damit zeitliche Auflösung des generierten Signals. Der Einsatz von bisher allgemein üblichen analogen Modulationsverfahren ist nicht möglich.

Das hier vorgestellte Verfahren ist rein digital; es kommt ohne Frequenz-Konversion und Filterung aus, ohne dadurch in der Möglichkeit, Modulations- bzw. Rauschsignale detailliert zu gestalten, beschränkt zu sein. Erforderlich ist nur eine gewisse Begrenzung des Modulations- bzw. Rauschsignals auf den Bereich um den Träger (schmalbandige Modulation bzw. schmalbandiges Rauschen). Diese Einschränkung ist für den Meßtechnikbereich nicht wesentlich, da auch hier eine gewisse Bandbegrenzung erwünscht ist. Die Komplexität des Verfahrens wird auf die Werteberechnung vorab verlegt, wofür ein effizientes mathematisches Verfahren bereitgestellt wird, das sich zur rechnergestützten Auswertung eignet. Dadurch können Modulations- bzw. Rauscheigenschaften erzeugt werden, die mit bisherigen Methoden nicht realisierbar waren. Durch die Vorabberechnung muß auch weiterhin auf Wertespeicherung zurückgegriffen werden. Im Vergleich zu dem Verfahren arbiträrer Wortgeneratoren ist hier jedoch eine um eine Größenordnung bessere Speicherausnutzung möglich, die entsprechend die Signalperiodizität vervielfacht und damit einem idealen Modulations- bzw. Rauschverhalten näher kommt.

Die Erfindung wird durch folgende Figuren näher erläutert. Es zeigen :

Fig. 1      einen schmalbandigen analogen HF-Rauschgenerator;

Fig. 2      einen schmalbandigen digitalen HF-Modulations-bzw. Rauschgenerator mit Multiplizierer;

Fig. 3      einen erfindungsgemäßen Schmalbandigen digitalen HF-Modulations- bzw. Rauschgenerator mit Addierer und

Fig. 4      erzeugte Rauschspektren.

Ein digitaler Modulations- bzw. Rauschgenerator kann durch eine digitale Realisierung des in Abb. 1 gegebenen Schemas aufgebaut werden. Solange ein schmalbandiges Modulations- bzw. Rauschsignal erzielt werden soll, muß bei der technischen Ralisierung aber nicht von einer digital nachgebildeten Quelle bestimmter Modulation bzw. weißen Rauschens mit anschließender Filterung ausgegangen werden. Hierzu wird ein Oszillator genutzt, der eigentlich ein reines Frequenzsignal erzeugen sollte. Als Oszillator findet ein digital gesteuerter Oszillator (NCO) Verwendung. Solche NC0s sind als integrierte Schaltbausteine kommerziell erhältlich. Die gewünschten Modulations- bzw. Rauschsignale werden durch geeignete simultane Amplituden- und Phasenmodulation des NCO's generiert. Wegen der dabei erforderlichen Präzision kann diese Modulation von vorneherein nur durch ein digitales System erzielt werden.

a) Rechenverfahren zur allgemeinen HF-Modulation gemäß Stand der Technik:
    Zuerst wird die komplexe Signalsequenz im Zeitbereich, S(t), generiert.
    Abbildung dieser Sequenz auf die Amplituden- und Phasenmodulationssequenz A(t) und $\psi$ (t),

$$S(t) = A(t) \exp[i \ \psi(t)] \exp [i2\Pi f]$$

bei gegebener Trägerfrequenz f ergibt dann

$$A(t) = \sqrt{S*(t)S(t)} \ \text{ und } \ \ \psi \ (t) = \text{arctg} \left[ i \frac{S*(t)\exp i2\pi ft - S(t)\exp -i2\pi ft}{S*(t)\exp i2\pi ft + S(t)\exp -i2\pi ft} \right].$$

Mit diesem Verfahren können wertelimitierte Signalsequenzen, insb. für bandlimitiertes Rauschen, mittels eines modulierbaren Oszillators erzeugt werden.

b) Rechenverfahren zur Rauschsignalerzeugung gemäß Stand der Technik:
    Eine wesentliche Grundlage der vorgelegten Erfindung ist der Nachweis, daß sich schmalbandige Rauschsignale als Modulationssignale beschreiben lassen. Hierfür werden mathematisch-algorithmische und technische Möglichkeiten vorgestellt. Die mathematische Begründung des Verfahrens ist allgemein gültig und exakt. Die tatsächlichen Grenzen einer technischen Realisierung sind letztlich durch die Miniaturisierungsgrenzen elektronischer integrierter Schaltungen mit den einhergehenden Packungsdichten und minimalen Signallaufzeiten gesetzt.
    Das Rechenverfahren soll für ein spezifisches gewünschtes Rauschsignal die Signalsequenz S(t) und, daraus folgend, die Modulationsgrößen (Datensequenzen) A und ψ berechnen, wie sie unter a) eingeführt wurden. Zur numerischen Erzeugung von weißem Rauschen existieren gängige Verfahren. Zur Erzeugung schmalbandigen Rauschens bieten sich dagegen folgende Möglichkeiten an:

Die für weißes Rauschen erzeugten Sequenzen werden mittels gängiger Methoden (FFT) in die Frequenzdomäne überführt und dort den erwünschten Rauscheigenschaften entsprechend gefiltert. Die dadurch entstandene Datensequenz in der Frequenzdomäne wird danach wieder in die Zeitdomäne rücküberführt und stellt dann die in a) gewünschte Signalsequenz S(t) dar. Diesem Verfahren gegenüber weist das nachfolgende Verfahren wesentliche Vorzüge auf.

Eine direkte Methode ergibt sich durch direktes Berechnen der Sequenz S(t) in der Zeitdomäne als Überlagerung sehr vieler, geeignet gewichteter Frequenzkomponenten im erwünschten Rauschband, deren relative Phasen zufällig gewählt wurden (Abtastung in der Frequenzdomäne). Dieses Verfahren vermeidet ganz die Hin- und Rücküberführung in die Frequenzdomäne per FFT und unterliegt daher im Hinblick auf die Sequenzlänge keinerlei prinzipiellen Beschränkungen. Dieses Verfahren ist wesentlicher Bestandteil der Erfindung.

c) Realisierung des Modulationsverfahrens mit Hilfe eines NC0s und eines Multiplizierers gemäß Stand der Technik (Abb. 2)

Kommerziell erhältliche numerische Oszillatoren verfügen mit wenigen Ausnahmen über eine Phasenmodulierbarkeit, jedoch (abgesehen von einer Ausnahme niedrigerer Taktfrequenz) nicht über eine Amplitudenmodulierbarkeit. Amplitudenmodulierbarkeit durch die Zuschaltung eines Multiplizierers ist daher naheliegend, da im analogen Bereich üblich. Multiplizierer sind als digitale Schaltungen verfügbar, erlauben jedoch in den erhältlichen Versionen nur eine geringere Taktung. Die Schaltgeschwindigkeit der Gesamtschaltung und damit die zu realisierenden Trägerfrequenzen sind deshalb derzeit durch den Multiplizierer begrenzt. Diese Begrenzung ist jedoch nicht prinzipieller Natur, sondern ergibt sich aus der derzeitigen Verfügbarkeit von kommerziellen Bausteinen. Dieses Verfahren ist aus der Literatur allgemein bekannt. Datenblätter einschlägiger Komponentenhersteller weisen auf diese Möglichkeit hin.

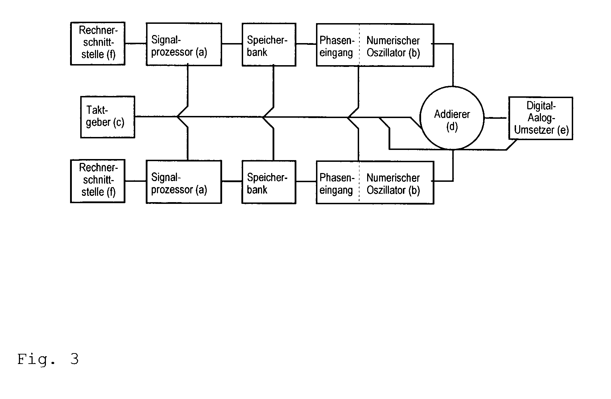

d) Erfindungsgemäße Realisierung des Modulationsverfahrens mit Hilfe zweier NC0s und eines Addierers (Abb. 3,)

Eine gleichwertige, dagegen technisch ganz neuartige Amplitudenmodulation kann durch Überlagerung zweier geeignet phasenmodulierter NC0s realisiert werden. Dieses Verfahren kann mit analogen Bauteilen nicht realisiert werden. Nur NC0s mit gemeinsamem Mutteroszillator (Taktgeber) können die erforderliche langzeitige starre Phasenkorrelation garantieren. Die jeweiligen Phasenmodulationssequenzen für die beiden NC0s errechnen sich aus den unter a) angegebenen Sequenzen als

$$\Phi_1(t) = \Psi(t) + \arccos\left[\frac{A(t)}{2A_{max}}\right]$$

und

$$\Phi_2(t) = \Psi(t) - \arccos\left[\frac{A(t)}{2A_{max}}\right].$$

Die Überlagerung der beiden NCO-Signale selbst wird durch einen digitalen Addierer bewerkstelligt, dessen Schaltungsaufwand wesentlich geringer ausfällt, als derjenige für einen Multiplizierer. Addierer sind als digitale Schaltungen verfügbar, erlauben jedoch wegen ihres einfacheren Aufbaus auch einen Zusammenbau (Hybridisierung) aus einzelnen Schaltzellen. So sind Addierer mit den heute bei NC0s üblichen Schaltgeschwindigkeiten realisierbar.

Gegenstand der Erfindung ist ein schmalbandiger HF-Modulationsgenerator mit der Möglichkeit arbiträrer, rein digital synthetisierter Amplituden- und Phasenmodulation bei freier Frequenzvariation, der insbesondere zur schmalbandigen HF-Rauscherzeugung geeignet ist. Der Generator besteht aus folgenden Funktionsblöcken (Abb. 3):

(a) zwei Signalprozessoren (DSP),
(b) zwei numerisch kontrollierte Oszillatoren (NCO),
(c) Taktgenerierung (CLOCK),

(d) digitaler Addierer (+),

(e) Digital-Analog-Umsetzer (DAU),

(f) Rechnerschnittstelle zur Ansteuerung.

Die hier als Funktionsnachweis tatsächlich präsentierte technische Realisierung als eine bevorzugte Ausführungsform der Erfindung kann Trägerfrequenzen von bis zu ca. 10 MHz bei Modalationsbandbreiten bis zu mehreren 100 KHz (üblicherweise bis zu 10 % der Trägerfrequenz) erzeugen. Sie basiert auf kommerziell verfügbaren und preisgünstigen elektronischen Bausteinen. Komponenten mit weitergehenden Leistungseigenschaften sind bereits erhältlich; auf einen Einsatz wurde jedoch aus Kostengründen verzichtet. Höhere Trägerfrequenzen bis zu 50 MHz und darüber sind heute möglich.

Die Ausführungsform ist modular aus Schaltungsplatinen zusammengesetzt, die weitestgehend aus kommerziellen hochintegrierten Schaltkreisen aufgebaut sind. Es umfaßt zwei Karten mit numerisch kontrollierten Oszillatoren (b), eine Taktgeberkarte (c), zwei digitale Signalprozessorkarten (a) sowie eine Addiererkarte (d) mit anschließender Digital-Analog-Umsetzer-Karte (e). Diese Lösung für einen rein digitalen schmalbandigen HF-Modulationsgenerator orientiert sich an der Verfügbarkeit kommerzieller integrierter Schaltkreise; sie erlaubt im Vergleich zu anderen denkbaren Lösungen die höchste Datenverarbeitungsrate und damit zeitliche Auflösung des generierten Signals.

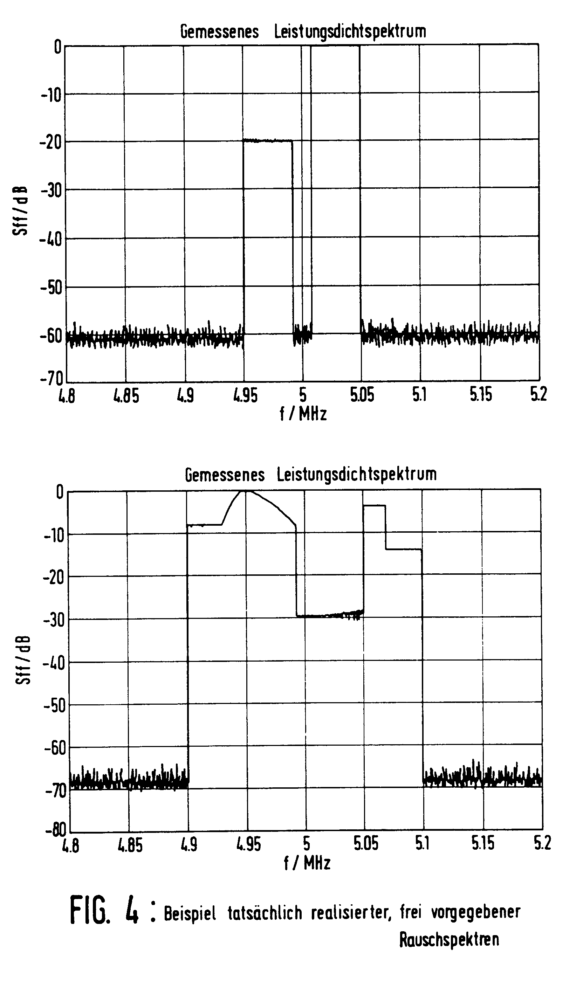

Mit dem beschriebenen Realisierungsmuster lassen sich z. B. die in Abb. 4 gezeigten (willkürlich konfigurierten) Rauschspektren erzeugen; zu beachten ist die Möglichkeit scharfer Limitierung in der Frequenzdomäne mit einer charakteristischen Steilheit von 1 dB/Hz sowie eine freie Vorgabe des Paßbandverhaltens.

HF-Modulation bzw. HF-Rauscherzeugung werden durch geeignete vorab in den Prozessoren berechnete parallele Phasenmodulations-Sequenzen der NC0s mit anschließender Signalsummierung erzielt. Die Sequenzen resultieren aus einer Abtastung im Frequenzbereich und erfordern keinerlei Filterung.

Dies erlaubt im Gegensatz zu herkömmlichen Methoden überlange Sequenzen mit entsprechend bisher unerreichbarer Frequenzauflösung. Das Verfahren ist nur durch die digitale Realisierung möglich. Resultate und Toleranzen sind präzis vorausberechenbar und stets reproduzierbar.

**Patentansprüche**

**1.** Digitaler, eine freie Vorgabe der Modulation von Frequenz, Phase und/oder Amplitude aufweisender Hochfrequenz-Modulationsgenerator mit digitalen, numerisch kontrollierten Oszillatoren (NCO) und nachgeschalteter Digital-Analog-Umsetzung, **gekennzeichnet durch**

- zwei geeignet phasenmodulierte, parallel laufende NCOs, deren Ausgangssignale zur simultanen Amplituden- und/oder Phasenmodulation ohne weitere Verwendung eines digitalen Multiplizierers in einem digitalen Addierer addiert werden, dessen Ausgangssignal einem Digital-Analog-Umsetzer zugeführt wird,
- zwei parallel laufende Prozessoren zur Vorausberechnung der in den NCOs einzugebenden Phasensequenzen und
- zwei parallele, den Prozessoren nachgeschaltete Speicherbänke zur Speicherung der jeweiligen Phasensequenzen zwecks nachfolgender Echtzeitübertragung an den jeweiligen NCO, wobei keine digitalen Filter vorgesehen sind.

**2.** Digitaler Hochfrequenz-Modulationsgenerator nach Anspruch 1,
**gekennzeichnet durch**
Nachschaltung zweier paralleler digitaler Echtzeitinterpolatoren zur zeitlichen Streckung, d. h. Verlängerung beider gespeicherter Phasensequenzen, um eine höhere Frequenzauflösung oder niedrigere Speichertiefe zu erzielen.

**3.** Schmalbandiger digitaler Hochfrequenz-Modulationsgenerator nach Anspruch 1 oder 2,
**dadurch gekennzeichnet,**
daß die beiden gespeicherten Phasensequenzen durch Abtastung in der Frequenzdomäne mittels eines willkürlich vorgebbaren Amplitudengangs und gleichzeitig zufällig gewählter Phase ermittelbar sind.

**Claims**

**1.** Digital high frequency modulation generator with freely pre-determinable modulation of frequency, phase and/or amplitude, having digital numerically controlled oscillators (NCOs), and, downstream, digital analogue conversion, characterised by

- two appropriately phase modulated parallel running NCOs whose output signals are added in a digital adder for simultaneous amplitude and/or phase modulation without further use of a digital multiplier, the output signals of the adder being fed to a digital analogue converter,
- two parallel running processors for pre-calculating the phase sequences to be inputted in the NCOs, and,
- two parallel memory banks, downstream of the processors, for storage of the respective phase sequences for the purpose of subsequent real time transmission to the respective NCO, no digital filter being provided.

2. Digital high frequency modulation generator according to claim 1, characterised by two downstream parallel digital real time interpolators for extending in time, i.e. for prolonging, the two stored phase sequences in order to achieve a higher frequency resolution or lower storage depth.

3. Narrow band digital high frequency modulation generator according to claim 1 or 2, characterised in that the two stored memory sequences can be determined by scanning in the frequency domain by means of a randomly pre-determinable amplitude characteristic and simultaneously randomly selected phase.

**Revendications**

1. Générateur numérique de modulation à haute fréquence, à prédétermination libre de la modulation de fréquence, de phase et/ou d'amplitude, comportant des oscillateurs numériques (NCO) contrôlés numériquement et un système de conversion numérique/analogique branché en aval, caractérisé par

- deux oscillateurs NCO qui sont modulés en phase de façon appropriée et fonctionnent en parallèle et dont les signaux de sortie sont additionnés pour réaliser une modulation simultanée d'amplitude et/ou de phase sans utilisation supplémentaire d'un multiplicateur numérique dans un additionneur numérique, dont le signal de sortie est envoyé à un convertisseur numérique/analogique,
- deux processeurs fonctionnant en parallèle et servant à réaliser le calcul préalable des séquences de phase devant être introduites dans les oscillateurs NCO, et
- deux blocs de mémoire parallèles, branchés en aval des processeurs et servant à mémoriser les séquences respectives de phase pour leur transmission ultérieure en temps réel à l'oscillateur NCO respectif, aucun filtre numérique n'étant prévu.

2. Générateur numérique de modulation à haute fréquence selon la revendication 1, caractérisé par le branchement aval de deux interpolateurs numériques en temps réel parallèles pour réaliser la dilatation dans le temps, c'est-à-dire l'allongement de deux séquences de phase mémorisées, pour l'obtention d'une résolution plus élevée en fréquence ou d'une profondeur plus faible de mémoire.

3. Générateur numérique de modulation à haute fréquence à bande étroite selon la revendication 1 ou 2, caractérisé en ce que les deux séquences de phase mémorisées peuvent être déterminées par échantillonnage dans un domaine des fréquences à l'aide d'une allure d'amplitude pouvant être prédéterminée à volonté et d'une phase choisie simultanément de façon aléatoire.

FIG. 1

FIG. 2

| Rechner-schnitt-stelle (f) | Signal-prozessor (a) | Speicher-bank | Phasen-eingang | Numerischer Oszillator (b) |
|---|---|---|---|---|

Takt-geber (c)

Addierer (d)

Digital-Aalog-Umsetzer (e)

| Rechner-schnitt-stelle (f) | Signal-prozessor (a) | Speicher-bank | Phasen-eingang | Numerischer Oszillator (b) |
|---|---|---|---|---|

Fig. 3

## Gemessenes Leistungsdichtspektrum

## Gemessenes Leistungsdichtspektrum

FIG. 4 : Beispiel tatsächlich realisierter, frei vorgegebener Rauschspektren